# EUROPEAN PATENT APPLICATION

(11) **EP 4 607 722 A1**
(43) Date of publication of application: **27.08.2025**
(21) Application number: 25158138.5
(22) Date of filing: 14.02.2025
(51) Int. Cl.: H01S 5/20, H01S 5/32, H01S 5/343, H01S 5/12, H01S 5/22

(54) **SEMICONDUCTOR LASER ELEMENT**

(30) Priority: 20.02.2024 JP 2024024031; 22.10.2024 JP 2024185840
(71) Applicant: NICHIA CORPORATION, Tokushima 774-8601 (JP)
(72) Inventor: IWAI, Akinori, Anan-shi, Tokushima, 774-8601 (JP)
(74) Representative: Betten & Resch

(57) **Abstract**

A semiconductor laser element includes an n-side cladding layer, a p-side cladding layer, and an active layer provided between the n-side cladding layer and the p-side cladding layer. The n-side cladding layer includes a semiconductor portion formed of a nitride semiconductor, and low-refractive index portions formed of a medium other than a nitride semiconductor and having a lower refractive index than a refractive index of the semiconductor portion.

## Description

### BACKGROUND

### 1. Technical Field

The present disclosure relates to a semiconductor laser element.

### 2. Description of Related Art

Semiconductor laser elements oscillate at a wavelength determined by the band gap energy of an active layer, and output coherent light that is uniform in phase and direction. A semiconductor laser element using a nitride semiconductor can oscillate in a wide wavelength range from an ultraviolet region to a red region according to the design of a material, and can be widely used as a light source for optical communication, optical recording and reproducing, sensing, a projector, and the like. When light is guided in a direction perpendicular to the stacking direction of a semiconductor laser element, an active layer is sandwiched between cladding layers having a lower refractive index than the refractive index of the active layer and light is confined in the vicinity of the active layer.

As an example of a surface emitting laser, a configuration in which photonic crystals are used in an optical guide layer adjacent to an active layer is known (see International Publication Pamphlet No. WO2018/155710, for example). In order to reduce light absorption in a p-side electrode located on the side of a stack opposite to the substrate side, a light-emitting device in which a low-refractive index part is provided in a p-side cladding layer is known (see Japanese Patent Publication No. 2019-83232, for example).

In a semiconductor laser element using a nitride semiconductor, when light is confined in the vicinity of an active layer by cladding layers, the choice of materials for the cladding layers is limited. It is conceivable to increase a difference in refractive index between a cladding layer and a core by changing the composition ratio of a semiconductor material of the cladding layer, but even if the composition ratio of the cladding layer is changed by about several percent (%) to 10% in percentage, the change in refractive index is, for example, about 5%. Due to the wavelength dependence of the refractive index, in particular, as the oscillation wavelength becomes longer in a visible light region, the change in refractive index caused by a mixed crystal becomes smaller, and thus the choice of materials is more and more limited. Conversely, if a semiconductor layer having a composition ratio different from the composition ratio of a substrate by 10% or more is grown to a thickness of several hundred nanometers while the crystal quality is maintained, a crack may occur.

### SUMMARY

According to an aspect of the present disclosure, a semiconductor laser element having good optical confinement can be provided.

According to one embodiment of the present disclosure, a semiconductor laser element includes an n-side cladding layer, a p-side cladding layer, and an active layer provided between the n-side cladding layer and the p-side cladding layer. The n-side cladding layer includes a semiconductor portion formed of a nitride semiconductor, and low-refractive index portions formed of a medium other than a nitride semiconductor and having a lower refractive index than a refractive index of the semiconductor portion.

### BRIEF DESCRIPTION OF THE DRAWINGS

FIG. 1 is a cross-sectional view orthogonal to the waveguide direction of a semiconductor laser element according to an embodiment;
FIG. 2 is a cross-sectional view taken along the waveguide direction of a stack of the semiconductor laser element of FIG. 1;
FIG. 3 is a cross-sectional view of a stack used in a semiconductor laser element according to a first embodiment;
FIG. 4 is a diagram illustrating the light intensity distribution of the semiconductor laser element of FIG. 3;
FIG. 5 illustrates a spectrum when the semiconductor laser element according to the first embodiment oscillates in a single mode;
FIG. 6 illustrates a spectrum when the semiconductor laser element according to the first embodiment oscillates in a multi-mode;
FIG. 7 is a cross-sectional view of a stack used in a semiconductor laser element according to a second embodiment;
FIG. 8 is a diagram illustrating the light intensity distribution of the semiconductor laser element of FIG. 7;
FIG. 9 is a cross-sectional view of a stack used in a semiconductor laser element according to a third embodiment;
FIG. 10 is a diagram illustrating the light intensity distribution of the semiconductor laser element of FIG. 9;
FIG. 11 is a cross-sectional view of a stack used in a semiconductor laser element according to a fourth embodiment; and
FIG. 12 is a diagram illustrating the light intensity distribution of the semiconductor laser element of FIG. 11.

### DETAILED DESCRIPTION

Embodiments of the present disclosure will be described with reference to the accompanying drawings. The following description is provided for the purpose of embodying the technical ideas underlying the present disclosure, but the present disclosure is not limited to the described embodiments unless specifically stated. In the drawings, members having the same functions may be denoted by the same reference numerals. In consideration of ease of explanation or ease of understanding of key points, configurations may be illustrated in separate embodiments for the sake of convenience; however, such configurations illustrated in different embodiments or examples can be partially substituted or combined with one another. A description of an embodiment given after a description of another embodiment will be focused mainly on matters different from those of the previously described embodiment, and a duplicate description of matters common to the previously described embodiment may be omitted. The sizes, positional relationships, and the like of members illustrated in the drawings may be exaggerated for a better understanding of the structures.

### (Configuration of Semiconductor Laser Element)

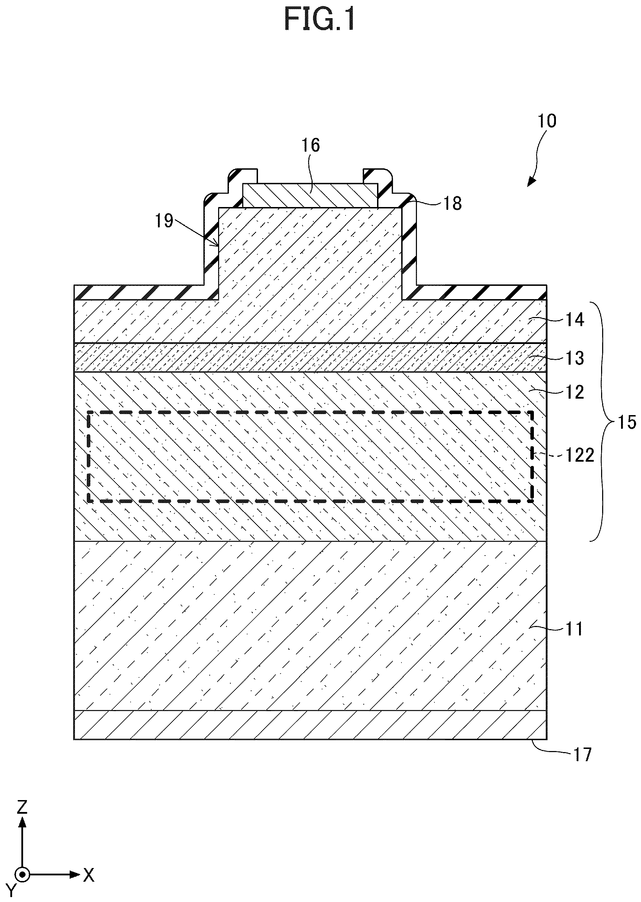

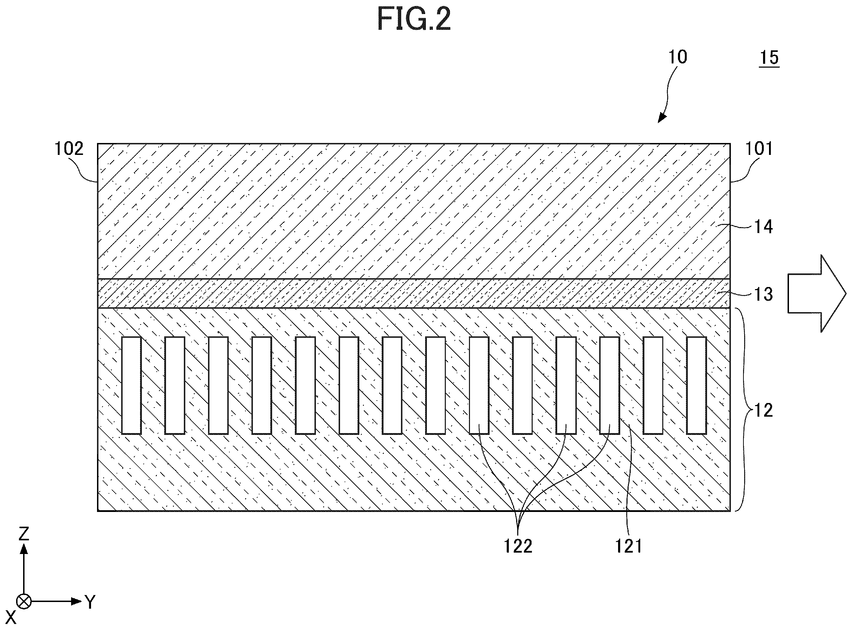

FIG. 1 is a cross-sectional view orthogonal to the waveguide direction of a semiconductor laser element 10 according to an embodiment. FIG. 2 is a cross-sectional view taken along the waveguide direction of a stack 15 of the semiconductor laser element 10 of FIG. 1. The waveguiding direction is a direction along a resonator length in which light repeatedly reflects. In a coordinate system illustrated in FIG. 1 and FIG. 2, the waveguide direction of the semiconductor laser element 10 is a Y direction, the stacking direction of the semiconductor laser element 10 is a Z direction, and a direction perpendicular to the Y direction and the Z direction is an X direction.

The semiconductor laser element 10 includes an n-side cladding layer 12, a p-side cladding layer 14, and an active layer 13 provided between the n-side cladding layer 12 and the p-side cladding layer 14. The n-side cladding layer 12 includes a semiconductor portion 121 formed of a nitride semiconductor, and low-refractive index portions 122 formed of a medium other than a nitride semiconductor. The refractive index of the low-refractive index portions 122 is lower than the refractive index of the semiconductor portion 121. Because the n-side cladding layer 12 includes the semiconductor portion 121 formed of a nitride semiconductor, and the low-refractive index portions 122 formed of a medium other than a nitride semiconductor having a lower refractive index than the refractive index of a nitride semiconductor, the refractive index of the entire n-side cladding layer 12 can be reduced and thus light confinement in the active layer 13 can be improved. Examples of the medium other than the nitride semiconductor include a gas such as air, a solid or semi-solid oxide, a resin, a polymer, and the like.

The n-side cladding layer 12, the active layer 13, and the p-side cladding layer 14 form the stack 15 constituting an optical waveguide of the semiconductor laser element 10. The Z-direction from the n-side cladding layer 12 toward the p-side cladding layer 14 is the stacking direction of the semiconductor laser element 10. As used herein, the term "cladding layer" refers to a layer having an optical function to confine light in a core. Each of the n-side cladding layer 12 and the p-side cladding layer 14 is a layer having a light confinement function for the active layer 13, and has a lower refractive index than the refractive index of the active layer 13. In a case where the active layer 13 has a quantum well structure including a well layer and a barrier layer, it can be said that each of the n-side cladding layer 12 and the p-side cladding layer 14 has a lower refractive index than the refractive index of the active layer 13 when the refractive index of each of the n-side cladding layer 12 and the p-side cladding layer 14 is lower than the refractive index of the well layer. When the refractive index of the n-side cladding layer 12 including the low-refractive index portions 122 is compared with the refractive index of the active layer 13, the effective refractive index of the n-side cladding layer 12 in consideration of the ratio between the semiconductor portion 121 and the low-refractive index portions 122 in the waveguide direction can be set as the refractive index of the n-side cladding layer 12. Alternatively, it may be said that the n-side cladding layer 12 has a lower refractive index than the refractive index of the active layer 13 when the refractive index of the semiconductor portion 121 is lower than the refractive index of the active layer 13. The same applies to a case where the p-side cladding layer includes low-refractive index portions. Either the n-side cladding layer 12 or the p-side cladding layer 14 or both the n-side cladding layer 12 and the p-side cladding layer 14 may be formed of a material having a lower refractive index than the refractive index of the active layer 13 and a band gap energy greater than the band gap energy of the active layer 13 so as to have a carrier confinement function in addition to the light confinement function. In the example illustrated in FIG. 1 and FIG. 2, for the sake of simplicity, semiconductor layers constituting the stack 15 are three layers, that is, the n-side cladding layer 12, the active layer 13, and the p-side cladding layer 14. The stack 15 can include other layers such as a p-side contact layer, an n-side contact layer, a p-side optical guide layer, and an n-side optical guide layer.

The semiconductor laser element 10 is driven by, for example, current injection. The semiconductor laser element 10 includes an electrode 16 (a p-side electrode) electrically connected to the p-side cladding layer 14, and an electrode 17 (an n-side electrode) electrically connected to the n-side cladding layer 12. The electrode 17 may be electrically connected to the n-side cladding layer 12 via another layer (for example, an n-side contact layer or an electrically-conductive substrate) provided between the electrode 17 and the n-side cladding layer 12. In the example of FIG. 1, the electrode 17 is provided on the back surface of an electrically-conductive substrate 11. However, the substrate 11 may be removed, and the electrode 17 may be provided on the back surface of an n-side contact layer provided as a part of an n-side semiconductor. In a case where the p-side cladding layer 14 is formed of a semiconductor, the electrode 16 may be electrically connected to the p-side cladding layer 14 via another layer (for example, a p-side contact layer) provided between the electrode 16 and the p-side cladding layer 14. The p-side cladding layer 14 is not limited to a semiconductor material as long as the p-side cladding layer 14 has the light confinement function for the active layer 13, and may be a layer of an electrically-conductive oxide such as ITO, IZO, or IZTO. In a case where the p-side cladding layer 14 is a layer of an electrically-conductive oxide, the p-side cladding layer 14 can also serve as a p-electrode.

In the example of FIG. 1, the stack 15 is processed into a shape of a ridge 19, and the surface of the stack 15 is covered by an insulating layer 18. The effective refractive index sensed by light emitted from the active layer 13 is increased at a portion where the thickness of the stack 15 is increased by the ridge 19, and thus the light is confined in the vicinity of the active layer 13 located directly below the ridge 19 in the lateral direction. The ridge 19 may be formed to a depth that does not reach the active layer 13, or may be formed to be deeper than the active layer 13. The ridge 19 is not essential for the semiconductor laser element 10, and the semiconductor laser element 10 does not necessarily include the ridge 19.

Laser light oscillated by the semiconductor laser element 10 may be ultraviolet light or visible light. The efficiency of a semiconductor laser element that oscillates blue laser light is highest among semiconductor laser elements using nitride semiconductors. In order for a semiconductor laser element to oscillate at a wavelength shorter than that of blue light, the band gap energy of the active layer 13 is made greater than that in the case of blue oscillation. In such a case, AlGaN having a relatively high aluminum (Al) composition ratio may be sometimes used as an n-side cladding layer 12. However, as the Al composition ratio increases, growing a high-quality n-side cladding layer 12 would become difficult. The use of the n-side cladding layer 12 according to the present embodiment allows both a reduction in refractive index and an improvement in crystallinity to be achieved. The semiconductor laser element 10 according to the present embodiment may be a semiconductor laser element that oscillates laser light in an ultraviolet region. Examples of the peak wavelength of the laser light oscillated by the semiconductor laser element 10 include 385 nm or less.

Further, in a case where the semiconductor laser element 10 oscillates at a wavelength longer than blue, as the wavelength becomes longer, a difference in refractive index caused by a difference in the composition ratio of a nitride semiconductor decreases due to wavelength dispersion. The active layer 13 includes, for example, an InGaN well layer. In such a case, the oscillation wavelength becomes longer as the In composition ratio of the well layer increases. However, as the In composition ratio increases, the crystallinity of a nitride semiconductor would tend to be deteriorated. Thus, it is desirable to improve the crystallinity of an n-side cladding 12 layer that also serves as an underlayer for forming an active layer 13. The use of the n-side cladding layer 12 according to the present embodiment allows both a reduction in refractive index and an improvement in crystallinity to be achieved. The semiconductor laser element 10 according to the present embodiment may be a semiconductor laser element that oscillates green laser light, or may be a semiconductor laser element that oscillates laser light having a longer wavelength. Examples of the peak wavelength of the laser light oscillated by the semiconductor laser element 10 include 460 nm or more.

In the n-side cladding layer 12, the semiconductor portion 121 formed of a nitride semiconductor is formed of, for example, AlₓGa₁₋ₓN, and has an Al composition ratio x of less than 0.04. The refractive index decreases as the Al composition ratio in AlGaN increases. However, even if the Al composition ratio x is set to about 0.1 (10% in percentage), there would be a case where a difference between the refractive index of the n-side cladding layer 12 and the refractive index of the active layer 13 (for example, the well layer) is insufficient. Further, as the Al composition ratio in AlGaN increases, growing a high-quality n-side cladding layer 12 would tend to be difficult. In particular, if a GaN substrate is used as the substrate 11, as the Al composition ratio in AlGaN increases, the difference in lattice constant between AlGaN and the substrate increases. Thus, as the Al composition ratio increases, growing AlGaN with high quality would become difficult. In light of this, according to the present embodiment, when the n-type semiconductor portion 121 of the n-side cladding layer 12 is formed of AlₓGa₁₋ₓN, the Al composition ratio x is set to be less than 0.04 and the low-refractive index portions 122 are included in the n-side cladding layer 12, thereby allowing the refractive index of the entire n-side cladding layer 12 to be reduced. Accordingly, a light confinement effect for the active layer 13 can be improved. Further, the crystallinity of the active layer 13 can be improved by improving the crystallinity of the n-side cladding layer 12 provided between the substrate 11 and the active layer 13. The semiconductor laser element 10 can include the substrate. The semiconductor laser element 10 does not necessarily include the substrate, and after the stack 15 is grown on the substrate, the substrate may be removed.

The n-side cladding layer 12 may be formed of one or more layers. In a case where the n-side cladding layer 12 includes a plurality of layers, at least one of the plurality of layers may be provided with the low-refractive index portion 122. The thickness of the at least one of the plurality of layers provided with the low-refractive index portions 122 is 50 nm or more, preferably 100 nm or more, and more preferably 500 nm or more. With this configuration, the low-refractive index portion 122 can be easily provided in the n-side cladding layer 12. Further, as the thickness of the at least one of the plurality of layers provided with the low-refractive index portions 122 increases, the height of each of the low-refractive index portions 122 in the thickness direction can be increased, and thus the refractive index of the n-side cladding layers 12 can be further reduced.

In a preferred configuration, when the integrated light intensity of in the stacking direction the semiconductor laser element 10 is set to 100%, the light intensity of the n-side cladding layer 12 is 5% or less. The active layer 13 is sandwiched between the n-side cladding layer 12 and the p-side cladding layer 14 so as to confine light in the active layer 13, but the light slightly leaks in the upper-lower direction (Z direction). In the present embodiment, the refractive index of the n-side cladding layer 12 is reduced by the low-refractive index portions 122, and thus the amount of light leaking to the n-side cladding layer 12 can be reduced and the light intensity of the n-side cladding layer 12 can be reduced. It is preferable that the n-side cladding layer 12 is provided such that the light intensity of the n-side cladding layer 12 is 5% or less of the integrated light intensity in the stacking direction of the semiconductor laser element 10. This allows the n-side cladding layer 12 to function well as a cladding layer. The integrated light intensity distribution of the n-side cladding layer 12 can be adjusted by the volume occupied by the low-refractive index portions 122, the proportion of the area occupied by the low-refractive index portions 122 in the n-side cladding layer 12 in a cross section taken along the waveguide direction, the distance from the active layer 13, and the like. The integrated light intensity distribution of the n-side cladding layer 12 can be adjusted by the volume occupied by the low-refractive index portion 122, the area ratio of the low-refractive index portion 122 in a cross section along the waveguide direction, the distance from the active layer 13, and the like. By causing the n-side cladding layer 12 alone including the low-refractive index portions 122 to function as a cladding layer, the semiconductor laser element 10 in which optical confinement is improved can be obtained with a simple structure. A composite layer consisting of the n-side cladding layer 12 and one or more layers adjacent to the n-side cladding layer 12 may function as a cladding layer. In this case, the one or more adjacent layers may be, for example, one or more AlGaN layers having an Al composition ratio x of more than 0.04. In a case where a composite layer consisting of the n-side cladding layer 12 and one or more layers adjacent to the n-side cladding layer 12 is caused to function as a cladding layer, the integrated light intensity distribution of the n-side cladding layer 12 provided with the low-refractive index portions 122 may set to be more than 5%.

A layer having a lower refractive index than the refractive index of the active layer 13 may be disposed between the active layer 13 and the n-side cladding layer 12. This can further reduce the light intensity of the n-side cladding layer 12. An Al_{y}Ga_{1-y}N layer having an Al composition ratio y of 0.04 or more may be disposed between the active layer 13 and the low-refractive index portions 122 of the n-side cladding layer 12. The thickness of the Al_{y}Ga_{1-y}N layer is preferably smaller than the thickness of the n-side cladding layer 12. This can suppress degradation of the crystallinity of the active layer 13 as a result of the Al_{y}Ga_{1-y}N layer being provided.

In the example of FIG. 2, each of the low-refractive index portions 122 is a void. When the low-refractive index portions 122 are voids, a manufacturing process can be simplified. The voids may be holes or grooves each having a shape of a cylinder, a polygonal prism, or an elliptic column, or the like. Air or any other gas may be present inside the voids formed in the semiconductor portion 121 formed of the nitride semiconductor. The low-refractive index portions 122 are not necessarily the voids. In such a case, the low-refractive index portions 122 can be obtained by filling voids with an inorganic material, a polymer, or a resin having a lower refractive index than the refractive index of the semiconductor portion 121. As the inorganic material having a lower refraction index than the refraction index of the semiconductor portion 121 formed of the nitride semiconductor, SiO₂, TiO₂, ZrO₂, Al₂O₃, SiN, SiON, or the like can be used. By providing the low-refractive index portions 122, the refractive index of the entire n-side cladding layer 12 is reduced. The refractive index of the entire n-side cladding layer 12 is, for example, a weighted average value of the refractive index of the semiconductor portion 121 and the refractive index of the low-refractive index portions 122. The weighting coefficient can be determined by, for example, the volume ratio between the semiconductor portion 121 and the low-refractive index portions 122 or the area ratio of the low-refractive index portions 122 in the X-Y plane.

The distribution of the low-refractive index portions 122 in the waveguide direction (Y direction) is periodic in a plane perpendicular to the stacking direction (Z direction) of the semiconductor laser element 10. By making the distribution of the low-refractive index portions 122 in the waveguide direction periodic, the light confinement of the semiconductor laser element 10 can be improved, and also the semiconductor laser element 10 can have wavelength selectivity. Alternatively, the distribution of the low-refractive index portions 122 in the waveguide direction may be random in a plane perpendicular to the stacking direction (Z direction) of the semiconductor laser element 10. In this case, the light confinement of the semiconductor laser element 10 in the upper-lower direction can be improved, and also a high light output can be achieved by causing multi-mode oscillation to occur.

In a case where the low-refractive index portions 122 have a periodic distribution in the waveguide direction in the XY plane perpendicular to the stacking direction and a period a of the low-refractive index portions 122 is an integer multiple of λ/(2 × n_{eff}), the semiconductor laser element 10 serves as a distributed-feedback (DFB) laser and oscillates in a single mode at a single wavelength. In the above λ/(2 × n_{eff}), λ is the oscillation wavelength of the semiconductor laser element 10 and n_{eff} is the effective refractive index of the semiconductor laser element 10 sensed by light having the wavelength λ. When the period a of the low-refractive index portions 122 is an integer multiple of λ/(2 × n_{eff}), the oscillation wavelength λ is equal to the energy or the wave number at the Brillouin Zone boundary.

The low-refractive index portions 122 may have a periodic distribution in a plane perpendicular to the stacking direction, and the period a of the low-refractive index portions 122 is not necessarily an integer multiple of λ/(2 × n_{eff}). The period "is not necessarily an integer multiple" does not mean that an error is allowed, but means that the period is intentionally designed to be shifted from an integer multiple of λ/(2 × n_{eff}). If the period a is not an integer multiple of λ/(2 × n_{eff}), the gain width of the active layer 13 does not include the energy of the Brillouin Zone boundary, or the upper end (the high energy side) of the gain width is less than the energy of the first Brillouin Zone. A wavelength at which the peak intensity ratio is 10% in a gain curve is defined as the end of the gain width. The gain width can be specified by observing the emission spectrum of the semiconductor laser element 10. For example, the period a may be set to 0.05 times or more and 0.95 times or less λ/(2 × n_{eff}). By setting the period a to be shifted from an integer multiple of λ/(2 × n_{eff}), preferably by setting the setting the period a to be shorter than λ/(2 × n_{eff}), the semiconductor laser element 10 can oscillate in a multi-longitudinal mode. A multi-longitudinal mode laser is suitable for applications in which productivity is required rather than precision, and can be applied to, for example, a light source of a projector, laser processing, and the like.

As will be described later, low-refractive index portions may be provided in the p-side cladding layer 14 in addition to the n-side cladding layer 12. In this case, the p-side cladding layer 14 includes a second semiconductor portion formed of a nitride semiconductor, and second low-refractive index portions formed of a material other than a nitride semiconductor and having a lower refractive index than the refractive index of the second semiconductor portion. With this configuration, the refractive indices of both the p-side cladding layer 14 and the n-side cladding layer 12 can be reduced, and light can be more effectively confined in the vicinity of the active layer 13. The second low-refractive index portions provided in the p-side cladding layer 14 may be holes or grooves each having a circular shape, a polygonal shape, a semicircular shape, an elliptical shape, or the like in a plan view in the Z direction. A gas such as air may be present inside the holes or the grooves, or the inside of the holes or the grooves may be filled with an inorganic material or a resin having a lower refractive index than the refractive index of the nitride semiconductor of the p-side cladding layer 14.

The second low-refractive index portions of the p-side cladding layer 14 may be arranged periodically or may be arranged randomly in the waveguide direction in the XY plane perpendicular to the stacking direction. The low-refractive index portions 122 of the n-side cladding layer 12 may be arranged periodically with a first period in the XY plane, the second low-refractive index portions of the p-side cladding layer 14 may be arranged periodically with a second period, and the first period and the second period may be different from each other. By making the first period and the second period different from each other, the low-refractive index portions are arranged randomly in the entire semiconductor laser element 10, and thus the semiconductor laser element 10 can oscillate in a multi-mode. The period of the low-refractive index portions 122 of the n-side cladding layer 12 in the waveguide direction may be the same as the period of the low-refractive index portions of the p-side cladding layer 14 in the waveguide direction. In this case, the semiconductor laser element operates as a DFB laser.

As illustrated in FIG. 2, the semiconductor laser element 10 has end surfaces 101 and 102 orthogonal to the waveguide direction (Y direction). As used herein, the expression "orthogonal to" the waveguide direction is not intended to mean that the end surfaces 101 and 102 form an angle of exactly 90° with respect to the longitudinal axis of a resonator, and the end surfaces 101 and 102 may be inclined by up to about ±5°. The end surfaces 101 and 102 may be reflecting surfaces using cleavage. Light generated in the active layer 13 is amplified while reciprocating between the end surfaces 101 and 102, and laser oscillation is produced by induced emission. As indicated by a white arrow in FIG. 2, when light is caused to exit from the end surface 101, a mirror of a metal film or a dielectric multilayer film having a high reflectance may be formed on the end surface 102 located opposite to the end surface 101. The mirror has a reflectance of 95% or more, preferably 98% or more, and more preferably close to 100%. Accordingly, optical amplification and oscillation can be efficiently performed.

### (Process of Manufacturing Semiconductor Laser Element)

The semiconductor laser element 10 illustrated in FIG. 1 and FIG. 2 can be manufactured by, for example, the following process.

### (N-Side Cladding Layer)

An n-side cladding layer 12 is formed on a substrate 11. A nitride semiconductor substrate such as GaN is used as the substrate 11. When a GaN substrate having a +c-plane ((0001) plane) as a primary plane is used, the n-side cladding layer 12 can be grown on the +c-plane in the c-axis direction. The +c-plane being used as the "primary plane" means that the primary plane may have an off-angle within ±1°. The n-side cladding layer 12 includes a single-layer or multilayer semiconductor portion 121 formed of a nitride semiconductor such as GaN, InGaN, or AlGaN. Among layers of the nitride semiconductor forming the semiconductor portion 121, a layer located at the interface with the substrate may be grown as a buffer layer.

The semiconductor portion 121 is formed of, for example, AlₓGa₁₋ₓN (x < 0.04). During or after the growth of a nitride semiconductor layer, the nitride semiconductor layer is doped with an n-type impurity such as Si, Ge, Sn, S, Ti, Zr, or O at a concentration of 5 × 10¹⁷ cm⁻³ or more and 5 × 10²⁰ cm⁻³ or less.

### (Low-Refractive Index Portions)

After the nitride semiconductor layer of the n-side cladding layer 12 is formed, a mask for forming holes or grooves is formed by a publicly-known photolithography method and etching. Instead of photolithography, electron beam lithography or a nanoimprint method may be used to form a mask pattern for etching. Etching of the holes or the grooves may be performed by a dry process or a wet process. If the low-refractive index portions 122 are to be formed in a fine pattern, it is preferable to use dry etching such as reactive ion etching (RIE).

In a case where the holes or the grooves formed in the n-side cladding layer 12 are caused to remain as voids and are used as the low-refractive index portions 122, the mask used for forming the holes or the grooves is removed, and a nitride semiconductor is grown from the surface of the semiconductor portion 121 by a metal organic chemical vapor deposition (MOCVD) method, a hydride vapor phase epitaxy (HVPE) method, or the like. By controlling growth conditions of the MOCVD method or the HVPE method, a nitride semiconductor layer such as GaN can be grown also in the lateral direction from the surface of the semiconductor portion 121. During the growth of the nitride semiconductor layer, the nitride semiconductor layer may be doped with an n-type impurity and used as a part of the n-side cladding layer 12. Alternatively, another substrate on which a p-side cladding layer 14 and an active layer 13 are formed may be prepared, and the active layer 13 may be bonded to the n-side cladding layer 12. The bonding between the semiconductor portion 121 of the n-side cladding layer 12 in which the holes or the grooves are formed and the active layer 13 formed on the other substrate may be surface activated bonding between nitride semiconductors.

The holes or the grooves formed in the n-side cladding layer 12 may be filled with a low-refractive index material such as SiO₂. In this case, the mask used for forming the holes or the grooves may be left without being removed. After the holes or the grooves are filled with the low refractive index material, the surface is planarized until the semiconductor portion 121 formed of the nitride semiconductor is exposed, and a nitride semiconductor such as GaN is grown by the MOCVD method, the HVPE method, or the like. By controlling growth conditions, the nitride semiconductor can be grown also in the lateral direction.

### (Active Layer)

An active layer 13 is grown on the n-side cladding layer 12. The active layer 13 is formed, for example, in a quantum well structure. The active layer 13 includes, for example, an InGaN well layer. The quantum well structure may be a single quantum well structure or a multi-quantum well structure. In the case of the multi-quantum well structure, a barrier layer having a band gap energy greater than the band gap energy of a well layer is disposed between adjacent ones of two or more well layers. A barrier layer located at the interface between the n-side cladding layer 12 and the active layer 13 may be used as an n-side optical guide layer. Similarly, the uppermost barrier layer of the active layer 13 may be used as a p-side optical guide layer. In this case, the n-side optical guide layer, the active layer 13, and the p-side optical guide layer form a waveguide core. The active layer 13 may be formed in a quantum well structure having a GaN well layer or an AlGaN well layer. In this case, even when the semiconductor portion 121 is GaN or AlGaN, a difference in band gap energy between the n-side cladding layer 12 and the well layer of the active layer 13 can be increased by providing the low-refractive index portions 122. Accordingly, the light confinement efficiency can be improved.

### (P-Side Cladding Layer)

A p-side cladding layer 14 is grown on the active layer 13. The p-side cladding layer 14 is a nitride semiconductor having a lower refractive index than the refractive index of the well layer included in the active layer 13, and is formed of, for example, AlGaN. In order to increase a difference between the refractive index of the p-side cladding layer 14 and the refractive index of the well layer of the active layer 13, the Al composition ratio of the p-side cladding layer 14 may be set in a range of, for example, more than 0 and 0.2 or less. The p-side cladding layer 14 is doped with Mg at a concentration of 1 × 10¹⁹ cm⁻³ or more and 1 × 10²¹ cm⁻³ or less as a p-type impurity. After the p-side cladding layer 14 is grown, the p-side cladding layer 14 may be processed into a shape of a ridge 19 illustrated in FIG. 1, but the ridge is not essential for the semiconductor laser element 10.

### (Electrodes and Mirror)

The surface of the p-side cladding layer 14 is covered by an insulating layer 18, an opening is formed at a position where an p-side electrode 16 is to be formed, and the p-side electrode 16 is formed. The p-side electrode 16 is formed by a publicly-known appropriate method such as a sputtering method, vacuum deposition, or a lift-off method. The p-side electrode 16 may be formed of a multilayer film of metals such as Ni/Au. An n-side electrode 17 is formed on the back surface of the substrate 11. In this case, the substrate 11 is an electrically-conductive substrate obtained by doping a GaN substrate with an n-type impurity such as Si. The substrate 11 may be thinned or removed, and the n-side electrode 17 may be formed on the back surface of an n-side contact layer formed as a part of the n-side cladding layer 12. The n-side electrode 17 may be formed of a multilayer film of metals such as Ti/Al. The insulating layer 18 may cover the lateral surfaces of a stack 15 that forms a waveguide. A mirror may be formed on the end surface 102 of the semiconductor laser element 10 in the waveguide direction by using a highly reflective metal film or a dielectric multilayer film. The mirror can be formed by a physical growth method such as vacuum deposition or sputtering, a chemical vapor deposition (CVD) method, or the like. The end surface 101 on the light emission side of the semiconductor laser element 10 may be a reflecting surface using cleavage.

In the following, various samples of semiconductor laser elements are manufactured and optical characteristics thereof are studied.

### (First Embodiment)

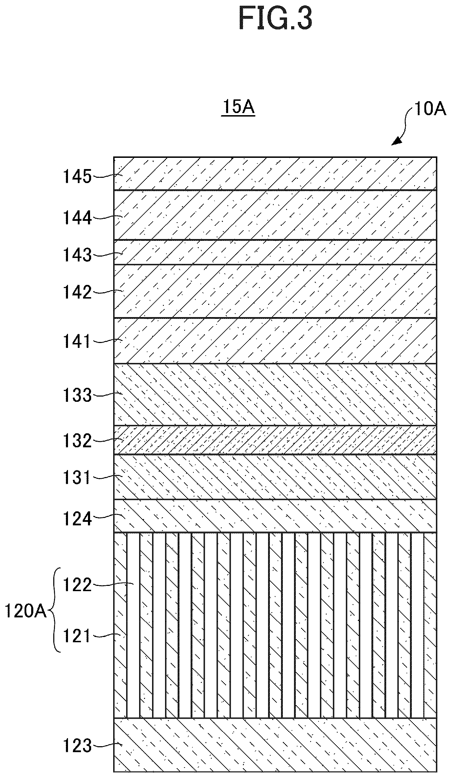

FIG. 3 is a cross-sectional view of a stack 15A used in a semiconductor laser element 10A according to a first embodiment. This cross section may be a cross section along the waveguide direction or a cross section orthogonal to the waveguide direction. The semiconductor laser element 10A includes an n-side cladding layer 120A. The n-side cladding layer 120A includes a semiconductor portion 121 formed of a semiconducting nitride, and low-refractive index portions 122 formed of a material other than a semiconducting nitride and having a lower refractive index than the refractive index of the semiconductor portion 121. The semiconductor portion 121 is formed of GaN containing an n-type impurity (hereinafter referred to as "n-GaN"). Each of the low-refractive index portions 122 is a void. An n-GaN layer 123 is provided under the n-side cladding layer 120A, and an n-GaN layer 124 is provided on the n-side cladding layer 120A. A GaN substrate may be provided under the n-GaN layer 123. The n-type semiconductor portion 121 of the n-side cladding layer 120A may be grown continuously from the n-GaN layer 123. The thickness of the n-side cladding layer 120A is 500 nm, and the thickness of the n-GaN layer 124 is 60 nm. In FIG. 3, the thickness of the low-refractive index portions 122 is equal to the thickness of the n-side cladding layer 120A, but the thickness of the low-refractive index portions 122 may be smaller than the thickness of the n-side cladding layer 120A.

An InGaN layer 131 having a thickness of 100 nm, an InGaN layer 133 having a thickness of 200 nm, and an active layer 132 having a thickness of 10 nm provided between the InGaN layers 131 and 133 are disposed on the n-GaN layer 124. The active layer 132 and the InGaN layers 131 and 133 sandwiching the active layer 132 from above and below can form a waveguide core. The InGaN layers 131 and 133 may be used as optical guide layers. The active layer 132 includes an InGaN well layer and a GaN barrier layer.

A GaN layer 141 having a thickness of 120 nm, an AlGaN layer 142 having a thickness of 130 nm, an AlGaN layer 143 having a thickness of 10 nm and doped with a p-type impurity (hereinafter referred to as "p-AlGaN"), a p-AlGaN layer 144 having a thickness of 100 nm, and a p-GaN layer 145 having a thickness of 20 nm are disposed on the InGaN layer 133 in this order. Each of the GaN layer 141 and the AlGaN layer 142 may function as a part of an optical guide layer. The p-AlGaN layer 143 may be used as an electron blocking layer. The p-AlGaN layer 144 functions as a p-side cladding layer. The Al composition ratio of the p-AlGaN layer 144 is higher than the Al composition ratio of the AlGaN layer 142, and the Al composition ratio of the p-AlGaN layer 143 is higher than the Al composition ratio of the p-AlGaN layer 144. The uppermost p-GaN layer 145 can be used as a p-side contact layer.

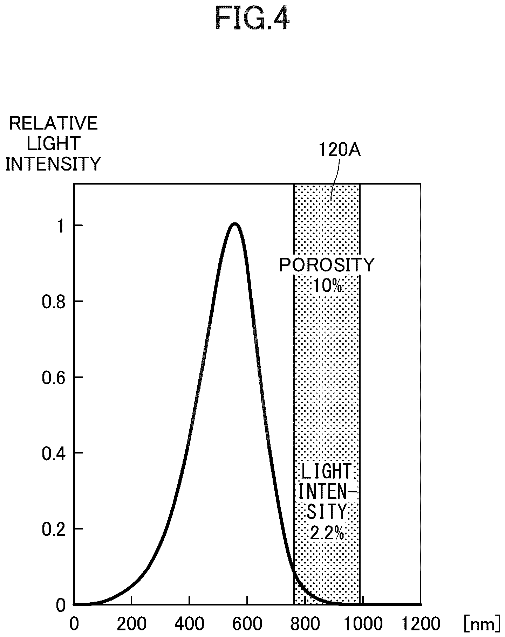

FIG. 4 is a diagram illustrating the light intensity distribution of the semiconductor laser element 10A of FIG. 3. The horizontal axis represents the depth position from the surface of the p-GaN layer 145, and the vertical axis represents the relative light intensity with the peak normalized to 1. The position of the peak coincides with the position of the active layer 132. A hatched region indicates the position of the n-side cladding layer 120A including the low-refractive index portions 122. The porosity of the n-side cladding layer 120A is 10%. As used herein, the "porosity" refers to the proportion of the area occupied by the low-refractive index portions 122 in the n-side cladding layer 120A in a plane perpendicular to the stacking direction. The light intensity distribution of the n-side cladding layer 10A is 2.2% with respect to the integrated light intensity of the semiconductor laser element 10A. It can be seen that providing the low-refractive index portions 122 reduces the amount of light leaking from the active layer 132 toward the outside of the n-side cladding layer 120A, thereby achieving effective light confinement.

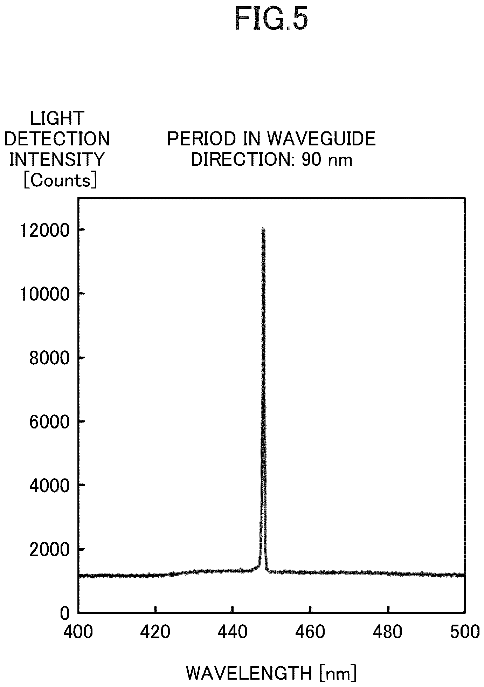

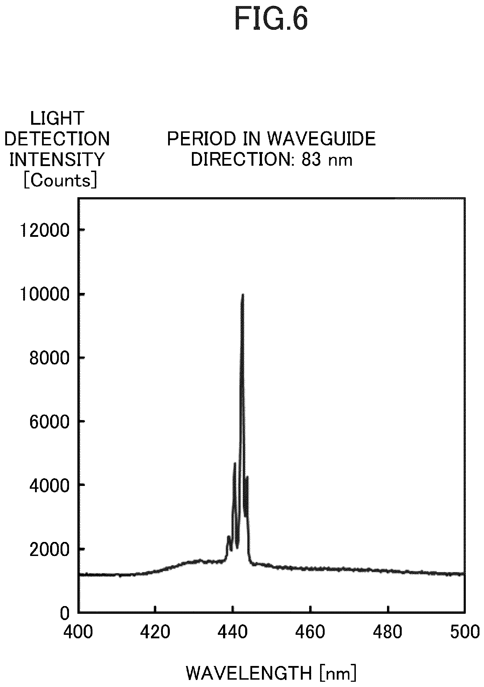

FIG. 5 illustrates a spectrum when the semiconductor laser element 10A according to the first embodiment oscillates in a single mode. FIG. 6 illustrates a spectrum when the semiconductor laser element 10A oscillates in a multi-mode. Specifically, two samples I and II of the semiconductor laser element 10A having the layer configuration of FIG. 3 are manufactured by varying the period of the low-refractive index portions 122 of the n-side cladding layer 120A in the waveguide direction. In the sample I, a period a1 of low-refractive index portions 122 in the waveguide direction is an integer multiple of λ/2n_{eff}. The sample II is designed such that a period a2 of low-refractive index portions 122 in the waveguide direction is shifted from an integer multiple of λ/2n_{eff}. A design oscillation wavelength λ of the semiconductor laser element 10A is 445 nm, and the effective refraction index n_{eff} of the semiconductor laser element 10A at this wavelength is 2.47.

The period a1 of the low-refractive index portions 122 in the waveguide direction of the sample I is set to be 90 nm, which is one times a1 = λ/2n_{eff}. At this time, as illustrated in FIG. 5, the semiconductor laser element 10A oscillates in a single mode at a wavelength of 445 nm determined by the period a1 and the effective refractive index n_{eff} of the medium. The period a2 of the low-refractive index portions 122 in the waveguide direction of the sample II is set to be 83 nm, which is shifted from an integer multiple of λ/2_{eff}. As compared to the sample I, the period a2 is shifted to the short pitch side, and the period a2 is 0.92 times λ/2_{eff}. At this time, as illustrated in FIG. 6, the semiconductor laser element 10A oscillates in a multi-longitudinal mode at a wavelength on the short wavelength side relative to the design wavelength.

As described above, with a configuration in which the low-refractive index portions 122 of the n-side cladding layer 120A are arranged periodically in the waveguide direction, the semiconductor laser element can oscillate in a single-longitudinal mode or in a multi-longitudinal mode based on whether the period a of the low-refractive index portions 122 is set to be an integer multiple of λ/2_{eff} or is set to be shifted from an integer multiple of λ/2_{eff}.

### (Second Embodiment)

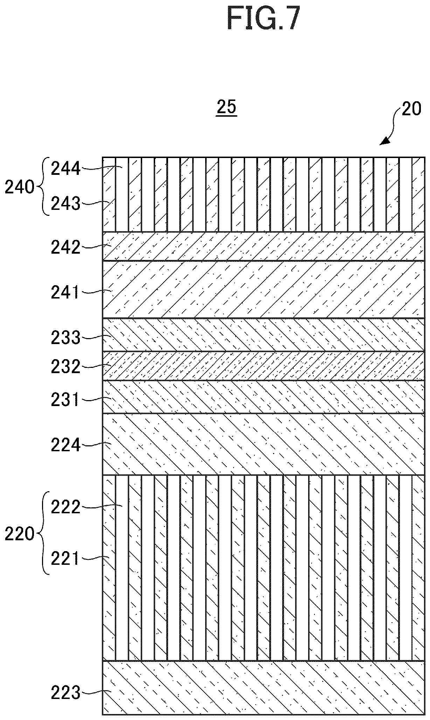

FIG. 7 is a cross-sectional view of a stack 25 used in a semiconductor laser element 20 according to a second embodiment. In the second embodiment, an n-side cladding layer and a p-side cladding layer are provided with low-refractive index portions. The semiconductor laser element 20 includes an n-side cladding layer 220, a p-side cladding layer 240, and an active layer 232 provided between the n-side cladding layer 220 and the p-side cladding layer 240. The n-side cladding layer 220 includes a semiconductor portion 221 formed of a nitride semiconductor, and low-refractive index portions 222 formed of a material other than a nitride semiconductor and having a lower refractive index than the refractive index of the semiconductor portion 221. The semiconductor portion 221 is formed of n-GaN. Each of the low-refractive index portions 222 is a void. An n-GaN layer 223 is provided under the n-side cladding layer 220, and an n-GaN layer 224 is provided on the n-side cladding layer 220. The thickness of the n-side cladding layer 220 is 500 nm, and the thickness of the n-GaN layer 224 is 200 nm. In FIG. 7, the thickness of the low-refractive index portions 222 is equal to the thickness of the n-side cladding layer 220, but the thickness of the low-refractive index portions 222 may be smaller than the thickness of the n-side cladding layer 220.

An InGaN layer 231 having a thickness of 30 nm, an InGaN layer 233 having a thickness of 30 nm, and the active layer 232 having a thickness of 10 nm and provided between the InGaN layers 231 and 233 are disposed on the n-GaN layer 224. The active layer 232 and the InGaN layers 231 and 233 sandwiching the active layer 232 from above and below can form a waveguide core. The InGaN layers 231 and 233 may be used as optical guide layers. The active layer 232 includes an InGaN well layer and a GaN barrier layer.

A GaN layer 241 having a thickness of 200 nm, a p-AlGaN layer 242 having a thickness of 10 nm, and the p-side cladding layer 240 having a thickness of 250 nm are disposed on the InGaN layer 233 in this order. The p-side cladding layer 240 includes a semiconductor portion 243 formed of p-GaN, and low-refractive index portions 244 having a lower refractive index than the refractive index of the semiconductor portion 243. In this example, each of the low-refractive index portions 244 is a void. The GaN layer 241 may be an optical guide layer. The p-AlGaN layer 242 can be used as an electron blocking layer. The p-side cladding layer 240 functions as a cladding layer that ensures light confinement in the active layer 232. In FIG. 7, the thickness of the low-refractive index portions 244 is equal to the thickness of the p-side cladding layer 240, but the thickness of the low-refractive index portions 244 may be smaller than the thickness of the p-side cladding layer 240. A p-side contact layer may be provided on the p-side cladding layer 240.

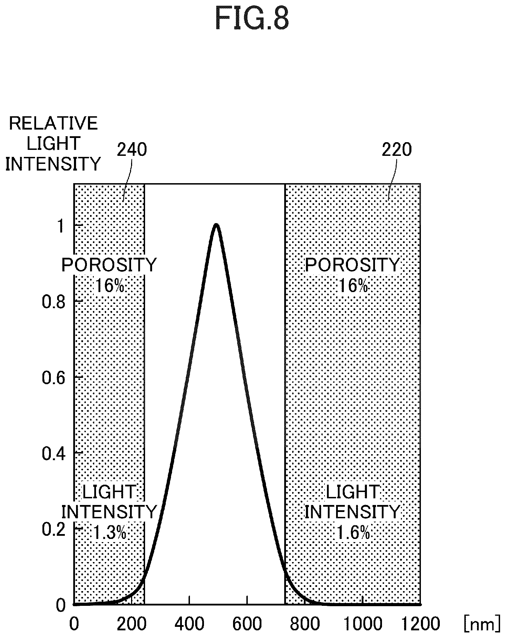

FIG. 8 is a diagram illustrating the light intensity distribution of the semiconductor laser element 20 of FIG. 7. The horizontal axis represents the depth position from the surface of the p-side cladding layer 240, and the vertical axis represents the relative light intensity with the peak normalized to 1. The position of the peak coincides with the position of the active layer 232. The porosity of the p-side cladding layer 240 is 16%, and the light intensity of the p-side cladding layer 240 is as low as 1.3% of the integrated light intensity of the entire semiconductor laser element 20. The porosity of the n-side cladding layer 220 is 16%, and the light intensity of the n-side cladding layer 220 is as low as 1.6% of the integrated light intensity of the entire semiconductor laser element 20. It can be seen that light is effectively confined in the vicinity of the active layer 232 by providing the p-side cladding layer 240.

The semiconductor laser element 20 oscillates in both a single-longitudinal mode and a multi-longitudinal mode by adjusting the arrangement of the low-refractive index portions 244 of the p-side cladding layer 240 and the low-refractive index portions 222 of the n-side cladding layer 220. That is, the semiconductor laser element 20 is configured to:
(a) oscillate in the single-longitudinal mode in a case where each of a period a1 of the low-refractive index portions 222 in the waveguide direction and a period a2 of the low-refractive index portions 244 in the waveguide direction is an integer multiple of λ/2n_{eff};
(b) oscillate in the multi-longitudinal mode in a case where the low-refractive index portions 222 and 244 are arranged with the same period a in the waveguide direction, but the period a is shifted from an integer multiple of λ/2n_{eff};
(c) oscillate in the multi-longitudinal mode in a case where the low-refractive index portions 222 and the low-refractive index portions 244 are arranged with different periods in the waveguide direction, and the entire semiconductor laser element 20 is non-periodic; and
(d) oscillate in the multi-longitudinal mode in a case where either the low-refractive index portions 222 or the low-refractive index portions 244 or both the low-refractive index portions 222 and the low-refractive index portions 244 are arranged randomly in the waveguide direction.

In any of the above cases, by adjusting the proportion occupied by the low-refractive index portions 222 in the n-side cladding layer 220 and the proportion occupied by the low-refractive index portions 244 in the p-side cladding layer 240, a difference in refractive index between the active layer 232 (well layer) and each of the n-side cladding layer 220 and the p-side cladding layer 240 can be adjusted, and light can be effectively confined in the vicinity of the active layer 232.

### (Third Embodiment)

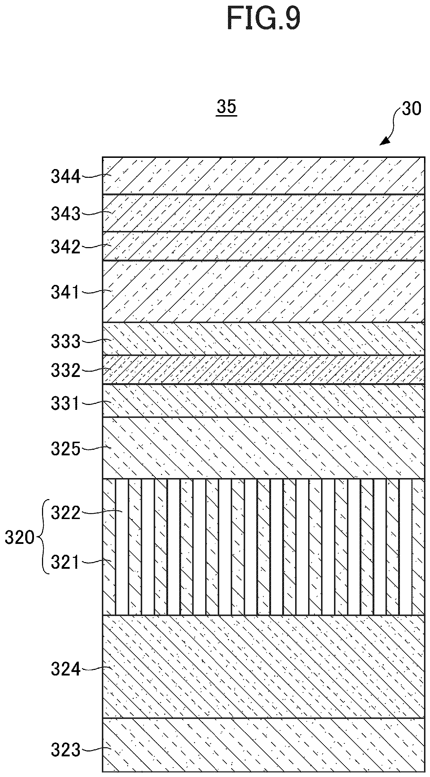

FIG. 9 is a cross-sectional view of a stack 35 used in a semiconductor laser element 30 according to a third embodiment. In the third embodiment, an Al_{y}Ga_{1-y}N layer having an Al composition ratio y of 0.04 or more is provided adjacent to an n-side cladding layer. The semiconductor laser element 30 includes an n-side cladding layer 320, a p-side cladding layer, and an active layer 332 provided between the n-side cladding layer 320 and the p-side cladding layer. The n-side cladding layer 320 includes a semiconductor portion 321 formed of a nitride semiconductor, and low-refractive index portions 322 formed of a material other than a nitride semiconductor and having a lower refractive index lower than the refractive index of the semiconductor portion 321. The thickness of the n-side cladding layer 320 is 500 nm. The semiconductor portion 321 is formed of n-GaN. Each of the low-refractive index portions 322 is a void. An n-AlGaN layer 324 having a thickness of 400 nm and an Al composition ratio y of 0.045 is provided under the n-side cladding layer 320, and an n-GaN layer 323 is provided under the n-AlGaN layer 324. A substrate may be provided under the n-GaN layer 323. The n-AlGaN layer 324 can be used as a part of the n-side cladding by being provided together with the n-side cladding layer 320. However, if the n-side cladding layer 320 is not provided, the n-AlGaN layer 324 alone does not sufficiently function as a cladding. The Al composition ratio y of the n-AlGaN layer 324 is 0.04 or more, but the n-AlGaN layer 324 has an Al composition ratio y that is low enough that the n-AlGaN layer 324 alone does not sufficiently function as a cladding. An n-GaN layer 325 having a thickness of 250 nm is provided on the n-side cladding layer 320. In FIG. 9, the thickness of the low-refractive index portions 322 is equal to the thickness of the n-side cladding layer 320, but the thickness of the low-refractive index portions 322 may be smaller than the thickness of the n-side cladding layer 320.

An InGaN layer 331 having a thickness of 30 nm, an InGaN layer 333 having a thickness of 30 nm, and the active layer 332 having a thickness of 10 nm and provided between the InGaN layers 331 and 333 are disposed on the n-GaN layer 325. The active layer 332 and the InGaN layers 331 and 333 sandwiching the active layer 332 from above and below can form a waveguide core. The InGaN layers 331 and 333 may be used as optical guide layers. The active layer 332 includes an InGaN well layer and a GaN barrier layer.

A GaN layer 341 having a thickness of 250 nm, a p-AlGaN layer 342 having a thickness of 10 nm, a p-AlGaN layer 343 having a thickness of 100 nm, and a p-GaN layer 344 having a thickness of 160 nm are disposed on the InGaN layer 333 in this order. The GaN layer 341 may function as a part of an optical guide layer. The p-AlGaN layer 342 can be used as an electron blocking layer. The p-AlGaN layer 343 can function as a p-side cladding layer. The Al composition ratio of the p-AlGaN layer 342 is higher than the Al composition ratio of the p-AlGaN layer 343. The uppermost p-GaN layer 344 can be used as a p-side contact layer.

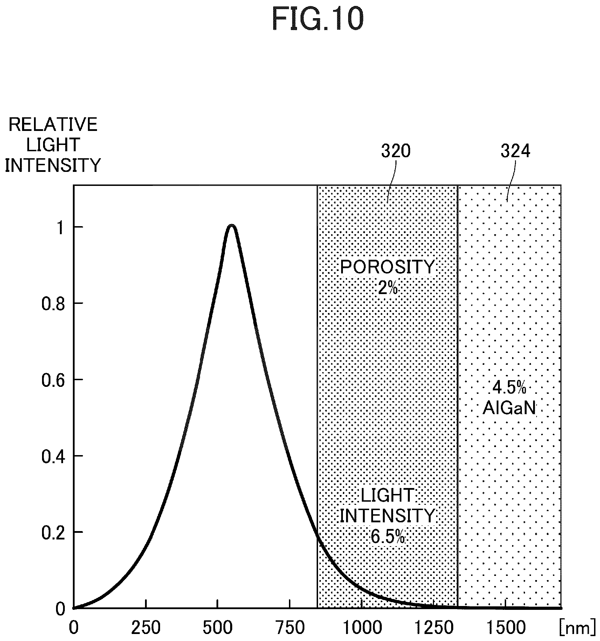

FIG. 10 is a diagram illustrating the light intensity distribution of the semiconductor laser element 30 of FIG. 9. The horizontal axis represents the depth position from the surface of the p-GaN layer 344, and the vertical axis represents the relative light intensity with the peak normalized to 1. The position of the peak coincides with the position of the active layer 332. The porosity of the n-side cladding layer 320 is 2%, and the light intensity of the n-side cladding layer 320 is 6.5% of the integrated light intensity of the entire semiconductor laser element 30. As described, when the n-side cladding layer 320 with small porosity is provided, the AlGaN layer 324 may be provided adjacent to the n-side cladding layer 320 so as to enhance the light confinement function. If the n-side cladding layer 320 is not provided, the Al composition ratio y and the thickness of the AlGaN layer 324 are preferably low enough and small enough that the AlGaN layer 324 alone does not sufficiently function as a cladding layer. With this configuration, the crystallinity of the active layer 332 can be improved.

By periodically forming the low-refractive index portions 322 in the waveguide direction, and setting the period a of the low-refractive index portions 322 to be shifted from an integer multiple of λ/2n_{eff}, the semiconductor laser element 30 can oscillate in a multi-mode.

### (Fourth Embodiment)

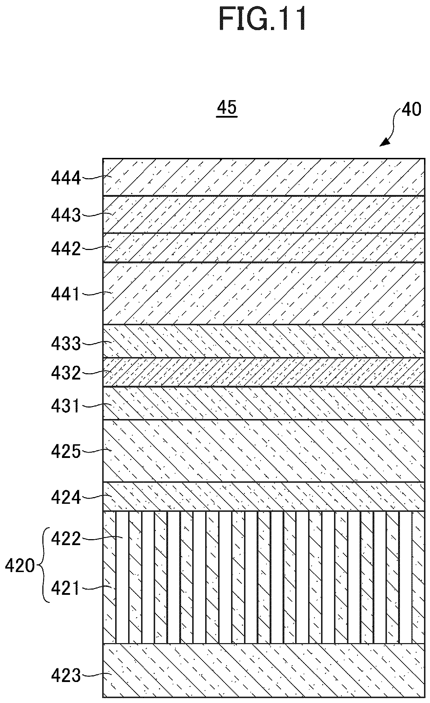

FIG. 11 is a cross-sectional view of a stack 45 used in a semiconductor laser element 40 according to a fourth embodiment. In the fourth embodiment, an AlGaN layer 424 having an Al composition ratio y of 0.04 or more (Al_{y}Ga_{1-y}N, y ≥ 0.04) is disposed between an n-side cladding layer and an active layer. The semiconductor laser element 40 includes an n-side cladding layer 420, a p-side cladding layer, and an active layer 432 provided between the n-side cladding layer 420 and the p-side cladding layer. The n-side cladding layer 420 includes a semiconductor portion 421 formed of a nitride semiconductor, and low-refractive index portions 422 formed of a material other than a nitride semiconductor and having a lower refractive index than the refractive index of the semiconductor portion 421. The thickness of the n-side cladding layer 420 is 400 nm. The semiconductor portion 421 is formed of n-GaN. Each of the low-refractive index portions 422 is a void. An n-AlGaN layer 424 having a thickness of 20 nm and an Al composition ratio y of 0.07 is provided between the n-side cladding layer 420 and the active layer 432, and an n-GaN layer 425 having a thickness of 250 nm is provided on the n-AlGaN layer 424. The Al composition ratio y of the n-AlGaN layer 424 is 0.04 or more, but the Al composition ratio y of the n-AlGaN layer 424 is low enough that the n-AlGaN layer 424 alone does not sufficiently function as a cladding layer if the n-side cladding layer 420 is not provided. In addition, the thickness of the n-AlGaN layer 424 is preferably small enough that the n-AlGaN layer 424 does not sufficiently function as a cladding layer if the n-side cladding layer 420 is not provided. Accordingly, the crystal quality of the active layer 432 can be improved. An n-GaN layer 423 may be provided under the n-side cladding layer 420. A substrate may be provided under the n-GaN layer 423. In FIG. 11, the thickness of the low-refractive index portions 422 is equal to the thickness of the n-side cladding layer 420, but the thickness of the low-refractive index portions 422 may be smaller than the thickness of the n-side cladding layer 420.

An InGaN layer 431 having a thickness of 30 nm, an InGaN layer 433 having a thickness of 30 nm, and the active layer 432 having a thickness of 10 nm and provided between the InGaN layers 431 and 433 are disposed on the n-GaN layer 425. The active layer 432 and the InGaN layers 431 and 433 sandwiching the active layer 432 from above and below can form a waveguide core. The InGaN layers 431 and 433 may be used as optical guide layers. The active layer 432 includes an InGaN well layer and a GaN barrier layer.

A GaN layer 441 having a thickness of 250 nm, a p-AlGaN layer 442 having a thickness of 10 nm, a p-AlGaN layer 443 having a thickness of 100 nm, and a p-GaN layer 444 having a thickness of 160 nm are disposed on the InGaN layer 433 in this order. The GaN layer 441 may function as a part of an optical guide layer. The p-AlGaN layer 442 can be used as an electron blocking layer. The p-AlGaN layer 443 functions as a p-side cladding layer. The Al composition ratio of the p-AlGaN layer 442 is higher than the Al composition ratio of the p-AlGaN layer 443. The uppermost p-GaN layer 444 can be used as a p-side contact layer.

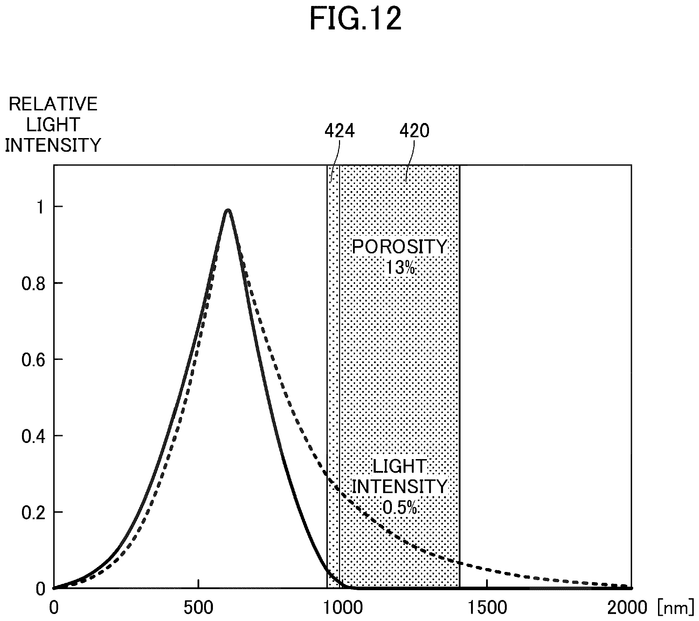

FIG. 12 is a diagram illustrating the light intensity distribution of the semiconductor laser element 40 of FIG. 11. The horizontal axis represents the depth position from the surface of the p-GaN layer 444, and the vertical axis represents the relative light intensity with the peak normalized to 1. The position of the peak coincides with the position of the active layer 432. The porosity of the n-side cladding layer 420 is 13%, and the light intensity of the n-side cladding layer 420 is 0.5% of the integrated light intensity of the entire semiconductor laser element 40. In FIG. 12, the solid line indicates the light intensity distribution of the semiconductor laser element 40, and the dashed line indicates the light intensity distribution of a semiconductor laser element according to a reference example. The semiconductor laser element according to the reference example is the same as the semiconductor laser element 40 except that no low-refractive index portions 422 are provided. Similar to the semiconductor laser element 40 according to the embodiment, the semiconductor laser element according to the reference example includes an n-AlGaN layer 424; however, if a cladding function is to be obtained by using only the n-AlGaN layer 424 without including low-refractive index portions 422, a sufficient light confinement effect cannot be obtained as indicated by the dashed line in FIG. 12. Conversely according to the embodiment, effective light confinement in the active layer 432 is achieved by including the low-refractive index portions 422. In the semiconductor laser element 40, it can be said that the n-side cladding layer 420 including the low-refractive index portions 422 substantially functions as a cladding layer.

The semiconductor laser element 40 can be used as a DFB laser by forming the low-refractive index portions 422 periodically in the waveguide direction and setting the period a of the low-refractive index portions 422 to be an integer multiple of λ/2n_{eff}. The semiconductor laser element 40 can oscillate in a multi-mode by forming the low-refractive index portions 422 non-periodically in the waveguide direction or setting the period a of the low-refractive index portions 422 in the waveguide direction to be shifted from an integer multiple of λ/2n_{eff}.

According to one embodiment of the present disclosure, a semiconductor laser element having good optical confinement can be provided.

### DESCRIPTION OF THE REFERENCE NUMERALS

10, 10A, 20, 30, 40 semiconductor laser element
11 substrate
12, 120A, 220, 320, 420 n-side cladding layer
121, 221, 321, 421 semiconductor portion
122, 222, 322, 422 low-refractive index portion
13, 132, 232, 332, 432 active layer
14, 240 p-side cladding layer
15, 15A, 25, 35, 45 stack
243 semiconductor portion (second semiconductor portion)
244 low-refractive index portion (second low-refractive index portion)
343, 443 p-AlGaN layer (p-side cladding layer)
24 AlGaN layer (Al_{y}Ga_{1-y}N, y ≥ 0.04)

## Claims

1. A semiconductor laser element comprising:
an n-side cladding layer;
a p-side cladding layer; and
an active layer provided between the n-side cladding layer and the p-side cladding layer, wherein
the n-side cladding layer includes
a semiconductor portion formed of a nitride semiconductor, and
low-refractive index portions formed of a medium other than a nitride semiconductor and having a lower refractive index than a refractive index of the semiconductor portion.

2. The semiconductor laser element according to claim 1, wherein the semiconductor portion of the n-side cladding layer is formed of AlₓGa₁₋ₓN and has an aluminum (Al) composition ratio x of less than 0.04.

3. The semiconductor laser element according to claim 1 or 2, wherein, when integrated light intensity in a stacking direction of the semiconductor laser element is set to 100%, light intensity of the n-side cladding layer is 5% or less.

4. The semiconductor laser element according to any one of claims 1 to 3, further comprising:
an Al_{y}Ga_{1-y}N layer provided between the active layer and the low-refractive index portions and having an Al composition ratio y of 0.04 or more.

5. The semiconductor laser element according to any one of claims 1 to 4, wherein each of the low-refractive index portions is a void.

6. The semiconductor laser element according to any one of claims 1 to 5, wherein a distribution of the low-refractive index portions in a waveguide direction is periodic in a plane perpendicular to a stacking direction of the semiconductor laser element.

7. The semiconductor laser element according to claim 6, wherein a period of the low-refractive index portions is not an integer multiple of λ/2n_{eff}, where λ represents an oscillation wavelength of the semiconductor laser element and n_{eff} represents an effective refractive index of the semiconductor laser element at the oscillation wavelength.

8. The semiconductor laser element according to any one of claims 1 to 5, wherein a distribution of the low-refractive index portions in a waveguide direction is random in a plane perpendicular to a stacking direction of the semiconductor laser element.

9. The semiconductor laser element according to any one of claims 1 to 5, wherein
the p-side cladding layer includes
a second semiconductor portion formed of a nitride semiconductor, and
second low-refractive index portions formed of a material other than a nitride semiconductor and having a lower refractive index than a refractive index of the second semiconductor portion.

10. The semiconductor laser element according to claim 9, wherein
the low-refractive index portions of the n-side cladding layer are arranged periodically with a first period,
the second low-refractive index portions of the p-side cladding layer are arranged periodically with a second period, and
the first period and the second period are different from each other.

11. The semiconductor laser element according to any one of claims 1 to 10, further comprising:
a substrate on which the n-side cladding layer is formed.

12. The semiconductor laser element according to claim 11, wherein
the low-refractive index portions are positioned away from the substrate.
